(19) Europäisches Patentamt
European Patent Office
Office européen des brevets

(11) Publication number: **0 254 589 B1**

(12) **EUROPEAN PATENT SPECIFICATION**

(45) Date of publication of patent specification: **16.10.91**

(51) Int. Cl.[5]: **H01L 31/18**, H01L 31/02, H01L 21/205

(21) Application number: **87306571.8**

(22) Date of filing: **24.07.87**

(54) **Process for preparation of semiconductor device.**

(30) Priority: **25.07.86 JP 173590/86**

(43) Date of publication of application:
**27.01.88 Bulletin 88/04**

(45) Publication of the grant of the patent:
**16.10.91 Bulletin 91/42**

(84) Designated Contracting States:
**DE FR GB**

(56) References cited:
**EP-A- 0 016 521**
**EP-A- 0 058 543**
**EP-A- 0 139 409**
**EP-A- 0 215 289**
**US-A- 4 406 765**

**ELECTRONICS LETTERS, vol. 18, no. 5, 4th March 1982, pages 211-213, London, GB; G.J.SMITH et al.: "Large-area low-frequency discharge-produced a-Si : H"**

**PATENT ABSTRACTS OF JAPAN, vol. 8, no. 239 (E-276)[1676], 2nd November 1984 & JP-A-59 119 876 (SUWA SEIKOSHA K.K.) 11-07-1984**

(73) Proprietor: **FUJITSU LIMITED**
**1015, Kamikodanaka Nakahara-ku**
**Kawasaki-shi Kanagawa 211(JP)**

(72) Inventor: **Takasaki, Kanetake**
**26-10-703, Omori Kita 1-chome Ota-ku**
**Tokyo 143(JP)**

(74) Representative: **Lawrence, Peter Robin Broughton et al**
**GILL JENNINGS & EVERY 53-64 Chancery Lane**
**London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services

## Description

The present invention relates to the preparation of semiconductor devices by a process involving improving the electrical characteristics of amorphous silicon. The resultant devices are useful as, for instance, photodiodes.

In the accompanying drawings Figure 2 shows an apparatus suitable for depositing an amorphous silicon film and Figure 3 shows a typical gap cell type photodiode.

The photodiode of Figure 3 comprises a glass substrate 11, an amorphous silicon film (a-Si:H film) 12, an Al electrode 13 and reference numeral 14 represents a white light of, for example, 1000 1x.

The apparatus in Figure 2 comprises a quartz jar 21 which serves as a reaction furnace, a heater 22, an electrode 23, a radio frequency (RF) generator 24, an inlet pipe 25 for gas, an exhaust opening 26 and a susceptor 28. The heater 22 heats the glass substrate 11 onto which amorphous silicon film is deposited during the process. The substrate and one end of the RF generator 24 are grounded, and when the RF generator 24 is turned on plasma 27 indicated by dots in Figure 2 is generated between the electrode 23 and the substrate 11, and Si of a silane gas ($SiH_4$) introduced through the gas-introducing pipe 25 is precipitated and deposited on the glass substrate 11 to form an amorphous silicon film (a-Si:H). A diluent gas such as $H_2$ or Ar may be added to $SiH_4$.

It is understood that the structure of the so-prepared amorphous silicon is as follows:

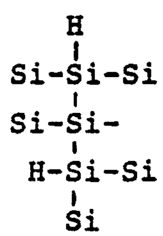

The plasma chemical vapour deposition process (CVD Process) using an exciting high frequency wave of 13.56 MHz has been adopted for formation of an amorphous silicon layer (e.g., Japanese Journal of Applied Physics, Vol. 21, No. 3, March, 1982, pp. 413-417). If this high frequency wave is used, the number of dangling bonds is small and amorphous silicon having excellent electrical characteristics [dark electroconductivity $\sigma d$ is small and bright electroconductivity (photoconductivity) $\sigma p$ is large] is easily obtained. However, this process is defective in that the formed amorphous silicon has poor heat durability (below 300°C) and poor adhesion to the glass substrate.

High heat durability at temperatures below 300°C is necessary since otherwise the manufacturing process is difficult. Good adhesion to the substrate is necessary as otherwise the amorphous silicon film tends to peel from the substrate. Small $\sigma d$ and large $\sigma p$ are preferred for the electrical characteristics, especially when the device is to be used as a photodiode.

It would therefore be desirable to be able to deposit an amorphous silicon film by a plasma CVD process using RF so as to provide an amorphous silicon layer that has satisfactory electrical properties and also has excellent heat durability and good adhesion.

According to the invention a semiconductor device is made by a process comprising plasma CVD of amorphous silicon onto a substrate in a deposition furnace in which the plasma is generated using a high frequency wave, and the high frequency wave has a frequency of less than 1 MHz and the resultant amorphous silicon is exposed to $O_2$ plasma.

In the preferred method of the invention the $O_2$ plasma is generated in the same deposition furnace as the furnace in which the amorphous silicon is deposited and the amorphous silicon is irradiated with the oxygen plasma, and thus the process can be conducted sequentially, with the oxygen irradiation following substantially immediately after the formation of the amorphous silicon.

It is understood that when the amorphous silicon film is exposed to $O_2$ plasma as described above, since $O_2$ plasma has a high activity, $O^*$ radicals are included in dangling bonds and the dark electroconductivity is further reduced.

Figure 1 is a graph illustrating the relationship between the time of irradiation with $O_2$ plasma and the electroconductivity in a-Si:H;

Figure 2 is a sectional view of the apparatus used in carrying out the present invention;

Figure 3 is a sectional view of a gap cell type photodiode;

Figure 4 is a diagram illustrating the localised level in a-Si:H.

The present invention will now be described in detail, by way of example, with reference to the accompanying drawings.

With reference to the structure of the amorphous silicon film again, during the growth of amorphous silicon, a-Si:H is formed by bonding H to Si in $SiH_4$ Although the number of dangling bonds is small in the growth of amorphous silicon, dangling bonds are still present, as is seen from the above-mentioned structural formula. When the amorphous silicon film is deposited using a high frequency wave having a frequence of, for instance, 13.56 MHz, the number of $SiH_2$ bonds is large. This

leads to poor heat durability and since the contribution of ions is small it also results in poor adhesion. However the number of dangling bonds is small and this produces excellent electrical characteristics. On the other hand, where the film is deposited using a lower frequency wave of, for instance, less than 1 MHz the number of $SiH_2$ bonds is small. This improves the heat durability and the contribution of ions is large and so this leads to excellent adhesion, but the number of dangling bonds is large and this leads to poor electrical characteristics.

When the conduction band and valence band of amorphous silicon are examined, it is seen that, as shown in Figure 4, a localised level indicated by a broken line is present between both bands, which is due to the presence of dangling bonds in the amorphous silicon. The dark electroconductivity of amorphous silicon depends on the conduction of electrons, indicated by black dots in Figure 4, thermally excited to the conduction band from the localised level. Therefore, a further decrease of the number of dangling bonds is effective for reducing the dark electroconductivity.

According to the present invention, an amorphous silicon film is grown at a high frequency on the glass substrate 11, for instance using the apparatus shown in Figure 2, and the supply of the $SiH_4$ gas is stopped and an $O_2$ gas is supplied instead into the quartz jar 21 to form $O_2$ plasma. The substrate 11 is irradiated with this $O_2$ plasma.

In the present invention, the plasma CVD process may be carried out under usual conditions except for the use of a relatively low frequency wave below 1 MHz, preferably 30 to 500 KHz. Then, the $O_2$ plasma treatment may be carried out under the conditions of a substrate temperature of 200 to 350°C, a pressure of 26.7 to 166.6 Pa (0.2 to 2 Torr). and a power of 50 to 500 mW/cm$^2$. The frequency is not critical in the $O_2$ plasma treatment, and a wave of a frequency of 30 KHz to 13.56 MHz may suitably be used.

The process may be carried out in the following manner. A vacuum of 133.3 Pa (1 Torr) is maintained in the quartz jar 21 and a high frequency wave having a low frequency of 200 KHz having a power of 100 mW/cm$^2$ is generated by the RF generator, and an $SiH_4$ gas is used for the growth of a-Si:H. After an a-Si:H film having a predetermined thickness, generally of about 1 µm, has been deposited, an $O_2$ gas is supplied instead of the $SiH_4$ gas. The time of irradiation with $O_2$ plasma is for at least 20 minutes, often 30 to 40 minutes. The so-obtained a-Si:H film is satisfactory in all of the heat durability, the adhesion to the substrate and the electrical characteristics. The frequency of the high frequency wave generated by RF is not limited to the above-mentioned value, and RF of the order of 30 KHz to 500 KHz can be used.

We examined the relation between the time of irradiation with $O_2$ plasma and the electroconductivity and obtained the results shown in Figure 1. Note, the $O_2$ plasma irradiation time, expressed by minutes, is plotted on the abscissa and the electroconductivity ($\Omega$-cm$^{-1}$), is plotted on the ordinate. In Figure 1, white circles and black circles indicate the photoconductivity and dark electroconductivity of a-Si:H formed by using a high frequency wave having a frequency of 200 KHz, respectively, and white triangles and black triangles indicate the photoconductivity and dark electroconductivity of a-Si:H formed by using a high frequency wave having a frequency of 13 MHz, respectively.

As shown in Figure 1, the dark photoconductivity of a-Si:H formed by a high frequency wave having a frequency of 200 KHz is higher before irradiation with $O_2$ plasma than that of a-Si:H formed by using a high frequency wave having a frequency of 13 MHz, but when irradiation with $O_2$ plasma is carried out for 30 minutes, the dark electroconductivity becomes substantially equal to that of a-Si:H formed by using a high frequency wave having a frequency of 13 MHz.

On the other hand, the photoconductivity of a-Si:H formed by using a high frequency wave having a frequency of 200 KHz is slightly higher before irradiation with $O_2$ plasma than that of a-Si:H formed by using a high frequency wave of 13 MHz, and the value of the photoconductivity is increased as the time of irradiation with $O_2$ plasma is prolonged.

Thus the irradiation with $O_2$ plasma leads to reduction of the dark electroconductivity and an increase in the photoconductivity, and yet the resultant a-Si:H film has a high heat durability (up to 450°C according to our experiments) and a good adhesion to the substrate. Thus for the first time it is possible to combine good electrical properties with good heat durability and adhesion properties. The resultant product is of particular value as a photodiode. If the a-Si:H is used for TFT, a transistor in which the $I_{on}/I_{off}$ ratio can be increased is obtained, and a solar cell in which the change with the lapse of time is small is obtained.

Although the plasma treatment after the plasma CVD deposition has also been carried out using, instead of the $O_2$ gas, a $H_2$, $CO_2$, CO, $N_2O$, $N_2$ or $NH_3$ gas, no significant improvement of the electrical characteristics of the deposited amorphous silicon film was attained.

## Claims

1. A process for manufacturing a semiconductor device comprising plasma CVD of amorphous

silicon onto a substrate in a deposition furnace in which the plasma is generated using a high frequency wave, characterised in that the high frequency wave has a frequency of less than 1 MHz and the resultant amorphous silicon film is exposed to $O_2$ plasma.

2. A process according to claim 1 in which the $O_2$ plasma is generated in the same deposition furnace and the amorphous silicon film is irradiated by the plasma in that furnace.

3. A process according to claim 1 or claim 2, in which the plasma chemical vapour deposition is carried out using a wave of a frequency of 30 to 500 KHz, preferably about 200 KHz.

4. A process according to claim 3, wherein the plasma chemical vapour deposition is carried out with a power of about 100 mW/cm$^2$ and preferably under a pressure of about 133 Pa (1 Torr).

5. A process according to any preceding claim, wherein the oxygen plasma treatment is carried out with a wave of a frequency of 30 KHz to 13.56 MHz.

6. A process according to any preceding claim, wherein the oxygen plasma treatment is carried out at a substrate temperature of 200 to 350 °C.

7. A process according to any preceding claim, wherein the oxygen plasma treatment is carried out under a pressure of 26.7 to 166.6 Pa (0.2 to 2 Torr).

8. A process according to any preceding claim, wherein the oxygen plasma treatment is carried out with a power of 50 to 500 mW/cm$^2$.

9. A process according to any preceding claim, in which the exposure to oxygen is conducted for at least 20 minutes.

10. A process according to any preceding claim, in which the semiconductor is a phctodiode.

**Revendications**

1. Procédé de production d'un dispositif semiconducteur comprenant la déposition plasma-chimique en phase vapeur de silicium amorphe sur un substrat dans un four à déposition, dans lequel le plasma est produit à l'aide d'une onde haute fréquence, caractérisé en ce que l'onde haute fréquence a une fréquence inférieure à 1 MHz et que le film de silicium amorphe obtenu est exposé à un plasma de $O_2$.

2. Procédé selon la revendication 1, dans lequel le plasma de $O_2$ est produit dans le même four à déposition et le film de silicium amorphe est irradié par le plasma dans ce four.

3. Procédé selon la revendication 1 ou 2, dans lequel la déposition plasma-chimique en phase vapeur est mise en oeuvre à l'aide d'une onde de fréquence comprise entre 30 et 500 kHz, de préférence d'environ 200 kHz.

4. Procédé selon la revendication 3, dans lequel la déposition plasma-chimique en phase vapeur est mise en oeuvre à une puissance d'environ 100 mW/cm$^2$ et de préférence sous une pression d'environ 133 Pa (1 Torr).

5. Procédé selon l'une quelconque des revendications précédentes, dans lequel le traitement par le plasma d'oxygène est mis en oeuvre à l'aide d'une onde de fréquence comprise entre 30 kHz et 13,56 MHz.

6. Procédé selon l'une quelconque des revendications précédentes, dans lequel le traitement par le plasma d'oxygène est mis en oeuvre pour une température du substrat comprise entre 200 et 350 °C.

7. Procédé selon l'une quelconque des revendications précédentes, dans lequel le traitement par le plasma d'oxygène est mis en oeuvre sous une pression comprise entre 26,7 et 166,6 Pa (0,2 à 2 Torr).

8. Procédé selon l'une quelconque des revendications précédentes, dans lequel le traitement par le plasma d'oxygène est mis en oeuvre à une puissance comprise entre 50 et 500 mW/cm$^2$.

9. Procédé selon l'une quelconque des revendications précédentes, dans lequel l'exposition à l'oxygène est opérée pendant un minimum de 20 min.

10. Procédé selon l'une quelconque des revendications précédentes, dans lequel le semiconducteur est une photodiode.

**Patentansprüche**

1. Verfahren zur Herstellung einer Halbleitervorrichtung, das Plasma-CVD von amorphem Silicium auf einem Substrat in einem Abscheidungsofen umfaßt, in welchem das Plasma unter Verwendung einer Hochfrequenzwelle erzeugt wird, dadurch gekennzeichnet, daß die Hochfrequenzwelle eine Frequenz von weniger als 1 MHz hat und der resultierende amorphe Siliciumfilm einem $O_2$-Plasma ausgesetzt wird.

**2.** Verfahren nach Anspruch 1, bei dem das $O_2$-Plasma in demselben Abscheidungsofen erzeugt wird und der amorphe Siliciumfilm durch das Plasma in dem Ofen bestrahlt wird.

**3.** Verfahren nach Anspruch 1 oder 2, bei dem die chemische Dampfabscheidung des Plasmas unter Verwendung einer Welle mit einer Frequenz von 30 bis 500 KHz, vorzugsweise etwa 200 KHz, durchgeführt wird.

**4.** Verfahren nach Anspruch 3, bei dem das chemische Dampfabscheiden des Plasmas mit einer Energie von etwa 100 $mW/cm^2$ und vorzugsweise unter einem Druck von etwa 133 Pa (1 Torr) durchgeführt wird.

**5.** Verfahren nach einem der vorherigen Ansprüche, bei dem die Sauerstoffplasmabehandlung mit einer Welle von einer Frequenz von 30 KHz bis 13,56 MHz durchgeführt wird.

**6.** Verfahren nach einem der vorhergehenden Ansprüche, bei dem die Sauerstoffplasmabehandlung bei einer Substrattemperatur von 200 bis 350 °C durchgeführt wird.

**7.** Verfahren nach einem der vorhergehenden Ansprüche, bei dem die Sauerstoffplasmabehandlung unter einem Druck von 26,7 bis 267 Pa (0,2 bis 2 Torr) durchgeführt wird.

**8.** Verfahren nach einem der vorhergehenden Ansprüche, bei dem die Sauerstoffplasmabehandlung mit einer Energie von 50 bis 500 $mW/cm^2$ durchgeführt wird.

**9.** Verfahren nach einem der vorhergehenden Ansprüche, bei dem die Exponierung gegenüber Sauerstoff wenigstens 20 Minuten lang durchgeführt wird.

**10.** Verfahren nach einem der vorhergehenden Ansprüche, bei welchen der Halbleiter eine Photodiode ist.

Fig. 1

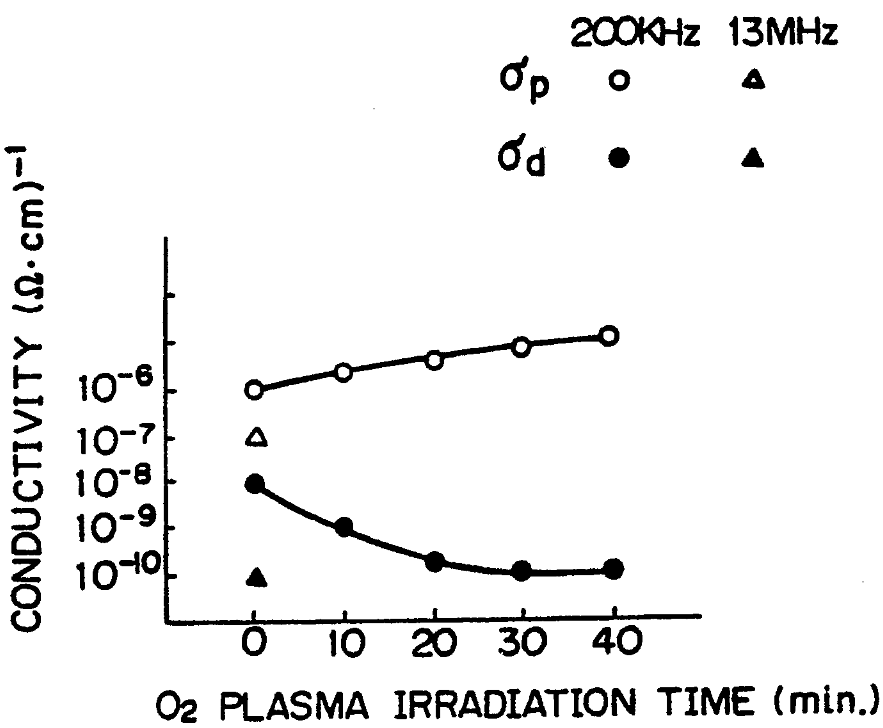
200KHz 13MHz
σp
σd
CONDUCTIVITY (Ω·cm)-1
10-6
10-7
10-8
10-9
10-10
0 10 20 30 40
O2 PLASMA IRRADIATION TIME (min.)

Fig. 2

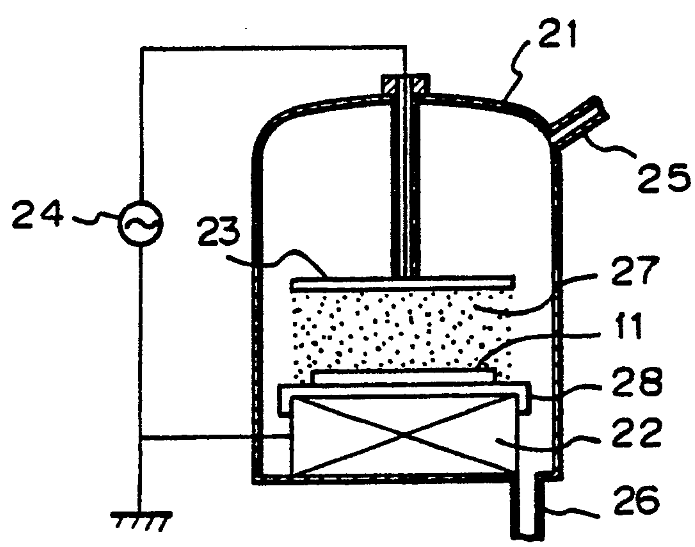
21
25
24
23
27
11
28
22
26

Fig. 3

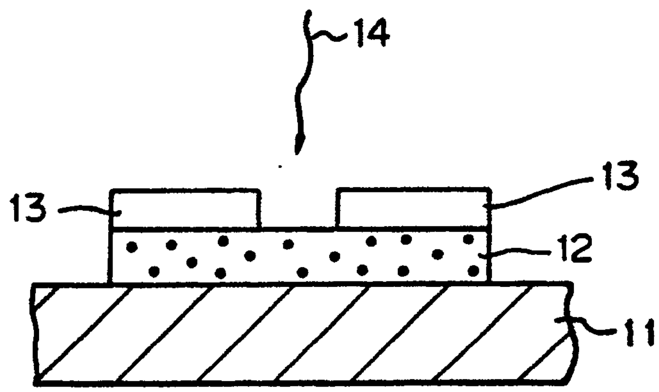
14
13
13
12
11

Fig. 4

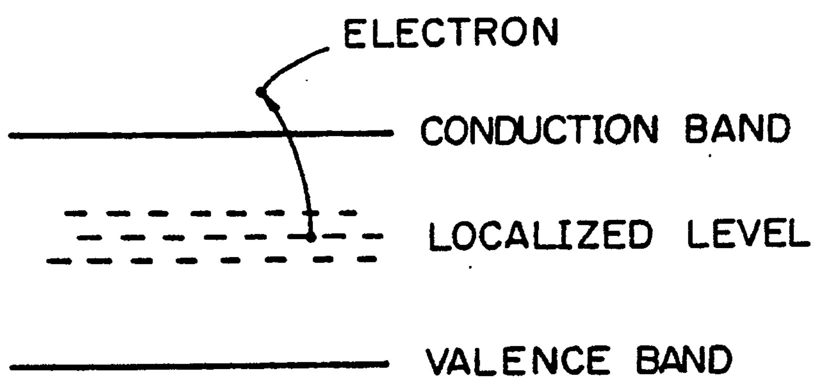
ELECTRON
CONDUCTION BAND
LOCALIZED LEVEL
VALENCE BAND